Europäisches Patentamt

European Patent Office

Office européen des brevets

(19)

(11) **EP 0 521 802 B1**

(12) **FASCICULE DE BREVET EUROPEEN**

(45) Date de publication et mention
de la délivrance du brevet:
**08.09.1999 Bulletin 1999/36**

(51) Int Cl.6: **H01L 29/866**

(21) Numéro de dépôt: **92420214.6**

(22) Date de dépôt: **23.06.1992**

(54) **Diode à avalanche dans un circuit intégré bipolaire**

Avalanche Diode in einer bipolaren integrierten Schaltung

Avalanche diode in a bipolar integrated circuit

(84) Etats contractants désignés:
**DE FR GB IT**

(30) Priorité: **28.06.1991 FR 9108418**

(43) Date de publication de la demande:
**07.01.1993 Bulletin 1993/01**

(73) Titulaire: **STMicroelectronics S.A.**
**94250 Gentilly (FR)**

(72) Inventeur: **Moreau, Jean-Michel**
**38100 Grenoble (FR)**

(74) Mandataire: **de Beaumont, Michel**
**1bis, rue Champollion**
**38000 Grenoble (FR)**

(56) Documents cités:
**EP-A- 0 082 331          GB-A- 2 130 792**
**US-A- 5 027 165**

- **PROC. IEEE 1990 CUSTOM INTEGRATED**
**CIRCUITS CONFERENCE, MAY 13-16 1990,**
**BOSTON, NEW-YORK, USA pages 1051 - 1054**
**R.J. BREWER 'A TECHNICAL STRATEGY FOR**
**MIXED ANALOG-DIGITAL CUSTOMS'**

## Description

La présente invention concerne le domaine des circuits intégrés bipolaires, et plus particulièrement la réalisation de diodes à avalanche destinées à servir de référence de tension dans de tels circuits.

Les diodes à avalanche ont été longuement étudiées, et l'on sait, quand on réalise des composants discrets, obtenir des diodes à avalanche satisfaisantes. Néanmoins, dans le cadre de la réalisation d'un circuit intégré, de nombreuses contraintes sont imposées, à savoir que l'on réalise simultanément un grand nombre de composants élémentaires et que tous ces composants doivent être réalisés en recourant à un minimum d'étapes technologiques.

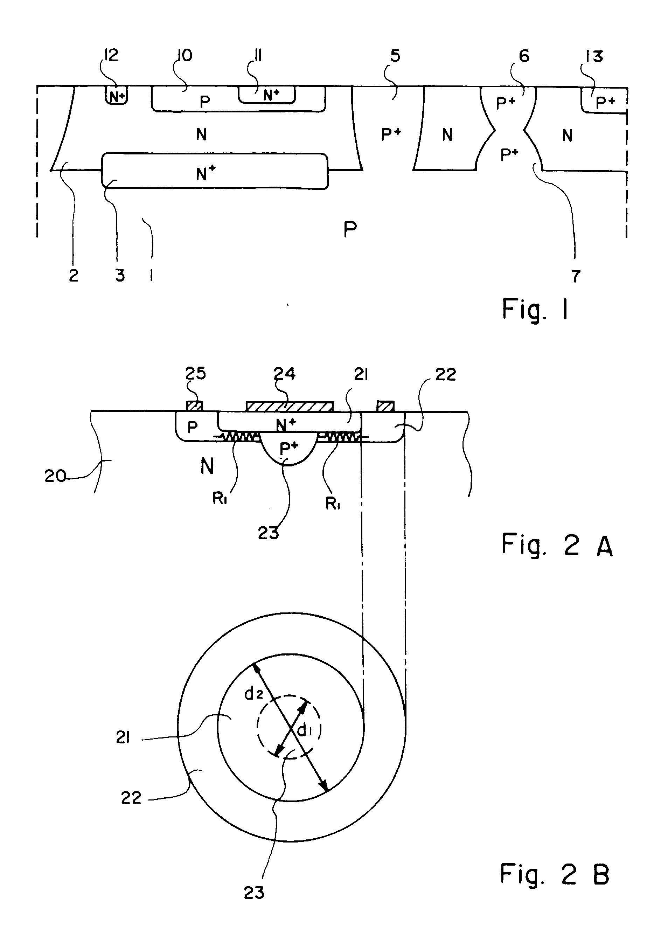

La figure 1 est destinée à rappeler les principales étapes technologiques et structures réalisables dans un circuit intégré bipolaire. Un tel circuit est généralement réalisé sur un substrat 1 d'un premier type de conductivité (généralement le type P) et sur lequel est formé une couche épitaxiée 2 d'un second type de conductivité (N). A l'interface entre le substrat 1 et la couche épitaxiée 2 peuvent être formées des couches enterrées 3 de type $N^+$, résultant d'une implantation effectuée dans le substrat avant l'épitaxie. La couche épitaxiée est divisée en caissons par des régions de diffusion profonde 5 de type $P^+$ ou bien par des diffusions moins profondes 6 s'étendant à partir de la surface et rejoignant des régions 7 résultant d'une implantation de type P dans la surface du substrat 1 avant l'épitaxie. Dans chacun des caissons, muni ou non d'une couche enterrée, on peut alors former divers types de composants. Le composant le plus fréquent est le transistor NPN comprenant une région P 10 correspondant à la base d'un transistor NPN. A l'intérieur de cette région P 10 est formée une région 11 de type $N^+$ correspondant à l'émetteur du transistor. Ces diffusions P 10 et $N^+$ 11 sont éventuellement utilisées dans d'autres structures qu'un transistor NPN. On continue toutefois quand on veut désigner leur nature et leur type de dopage à les appeler diffusions P de base pour les régions formées en même temps que la base et diffusions N d'émetteur pour les régions formées en même temps que les émetteurs des transistors NPN. Par exemple, le contact de collecteur du transistor NPN est réalisé sur une région $N^+$ 12 qui est une diffusion N d'émetteur. En outre, et comme cela est représenté à la droite de la figure 1, il est généralement prévu de créer des régions de type $P^+$ 13, servant par exemple d'émetteur et de collecteur pour des transistors PNP de puissance.

En résumé, à partir de la surface d'un caisson de type N, on peut former :

- une première région de type P correspondant à la base des transistors NPN,
- une deuxième région de type P correspondant aux émetteurs des transistors PNP,
- une troisième région de type P correspondant à une diffusion d'isolement (diffusion d'isolement complète telle que la diffusion 5 ou diffusion d'isolement partielle telle que la diffusion 6),
- une diffusion de type $N^+$ correspondant aux émetteurs des transistors NPN.

On peut a priori former des diodes à avalanche en polarisant en inverse une jonction formée à partir de deux régions quelconques de type opposé parmi les régions susmentionnées.

Dans la pratique, on s'est aperçu que l'une des structures de diode à avalanche donnant les résultats les plus satisfaisants était une structure du type illustré dans la vue en coupe de la figure 2A et dans la vue de dessus de la figure 2B. Cette diode à avalanche est réalisée dans un caisson N 20 (on n'a pas représenté le substrat P sousjacent). Elle comprend une région $N^+$ d'émetteur 21 formée dans une région P de base 22. Sensiblement au centre de la région 21 a été préalablement formée une diffusion P à niveau de dopage élevé 23, de sorte que c'est l'interface entre la région N 21 et la région P 23 qui correspond à la jonction susceptible de fournir l'effet d'avalanche. Ceci est destiné à obtenir de part et d'autre de la jonction des concentrations sensiblement homogènes de dopant N et de dopant P pour que la surface d'avalanche soit nettement définie. En effet, en l'absence de cette région 23, la jonction d'avalanche serait la jonction entre la région 21 et la région 22. Comme la région P 22 a été obtenue par diffusion, son niveau de dopage est plus élevé en surface qu'en profondeur et l'avalanche tendrait à se produire préférentiellement vers la surface, ce qui présente de nombreux inconvénients quant à la définition de la surface de jonction susceptible de venir en avalanche et quant aux caractéristiques de la jonction d'avalanche puisque ce sont les surfaces supérieures d'une couche qui sont le plus susceptibles d'être polluées et de se dégrader au cours du temps. En effet, des charges électriques mobiles peuvent se trouver dans l'oxyde qui recouvre les surfaces de jonction. La présence de ces charges modifie les conditions d'avalanche, et il en résulte un excès de bruit et souvent une dérive dans le temps de la valeur de la tension d'avalanche.

Bien entendu, la région $N^+$ 21 est nettement plus dopée que la région $P^+$ 23 pour que cette diffusion $P^+$ soit largement compensée au niveau de la région $N^+$. La région $P^+$ 23 peut, par exemple, correspondre à une région P d'émetteur de transistor PNP ou à une région P d'isolement. Une métallisation 24 est prévue sur la région N 21 et une métallisation 25 est prévue sur la surface apparente de la région P 22.

Ainsi, la structure décrite présente l'avantage d'une bonne définition de tension d'avalanche. De préférence, la surface de jonction est aussi faible que possible dans le domaine de la technologie choisie pour que la densité de courant circulant dans cette diode soit relativement élevée ce qui fournit une définition plus fiable (moins bruitée) de la tension d'avalanche ce qui est nécessaire pour définir une tension de référence. Toutefois, un inconvénient de cette structure est que le courant d'avalanche va être amené à circuler dans la partie annulaire de la région P 22, désignée par la résistance $R_1$, pincée entre la diffusion $N^+$ 21 et la couche épitaxiée 20. Cette région pincée a une résistance relativement élevée qui est définie avec une relative imprécision et qui dépend de la précision du positionnement relatif des régions 21 et 23. En conséquence, la tension d'avalanche qui est bien définie au niveau de la jonction entre les régions 21 et 23 est moins précisément définie entre les électrodes 24 et 25 en raison de l'existence de la résistance d'accès R1. Si la structure a une allure circulaire comme cela est représenté dans la vue de dessus de la figure 2B, la résistance de la région pincée susmentionnée sera :

$$R_1 = r/2\pi \ \mathrm{Log}(d2/d1)$$

où

r désigne la résistance par carré de la couche P22,
d1 désigne le diamètre de la région de jonction entre les couches 21 et 23, et
d2 désigne le diamètre de la région de jonction sensiblement horizontale entre les régions 21 et 22.

Pour réduire la valeur de $R_1$, il faudrait que d1/d2 soit proche de 1. Toutefois, on ne peut pas jouer sur ces valeurs qui sont imposées par le fait, d'une part, que le diamètre dl doit être aussi faible que possible pour obtenir une forte densité de courant au niveau de la jonction pour éviter que la diode à avalanche soit bruiteuse et, d'autre part, que la différence entre les valeurs d1 et d2 est fixée par les paramètres de la technologie et notamment par la précision de positionnement de deux masques successifs.

Ainsi, un objet de la présente invention est de prévoir une nouvelle structure de diode à avalanche applicable à un circuit intégré et n'utilisant pas d'étape de fabrication autre que les étapes normalement prévues dans un circuit intégré bipolaire, cette structure étant telle que la résistance d'accès à la diode à avalanche soit réduite.

Pour atteindre cet objet, la présente invention prévoit une diode à avalanche formée dans un circuit intégré bipolaire comprenant, dans une couche d'un premier type de conductivité ayant une première surface, une première région du deuxième type de conductivité s'étendant à partir de la première surface, une région du premier type de conductivité disposée à l'intérieur de la première région de sorte que la portion de la première région disposée sous la région du premier type de conductivité et au voisinage de l'interface avec celle-ci présente un premier niveau de dopage, une deuxième région du deuxième type de conductivité s'étendant sous la région du premier type de conductivité avec un deuxième niveau de dopage supérieur au premier au voisinage de la jonction, et une troisième région du deuxième type de conductivité disposée sous la région du premier type de conductivité et débordant par rapport à la deuxième région du deuxième type de conductivité, tout en restant à l'intérieur du contour de la région du premier type de conductivité, cette troisième région ayant au niveau de son interface avec la région du premier type de conductivité un niveau de dopage intermédiaire entre les premier et deuxième niveaux de dopage.

Selon un mode de réalisation de la présente invention, la couche du premier type de conductivité correspond à la couche épitaxiée de type N du circuit intégré bipolaire ; la première région correspond aux régions de base de type P de transistors NPN du circuit intégré bipolaire ; la deuxième région correspond aux régions d'émetteur de type P de transistors PNP du circuit intégré bipolaire ; la troisième région correspond aux diffusions d'isolement de type P du circuit intégré bipolaire ; et la région du premier type de conductivité correspond aux régions d'émetteur des transistors NPN du circuit intégré bipolaire. Ces diverses régions ont de préférence des contours circulaires.

Ces objets, caractéristiques et avantages ainsi que d'autres de la présente invention seront exposés en détail dans la description suivante d'un mode de réalisation particulier faite en relation avec les figures jointes parmi lesquelles :

la figure 1 représente divers aspects d'un circuit intégré bipolaire classique ;
les figures 2A et 2B représentent en coupe et en vue de dessus une structure de diode à avalanche classique utilisée dans un circuit intégré bipolaire ; et
les figures 3A et 3B représentent une vue en coupe et une vue de dessus d'une diode à avalanche selon la présente invention.

Conformément à l'usage dans le domaine de la représentation des composants semiconducteurs, ces diverses figures sont fortement schématiques et ne sont pas dessinées à l'échelle. Notamment, les formes courbes des bords de jonction résultant des diffusions ne correspondent pas à la réalité.

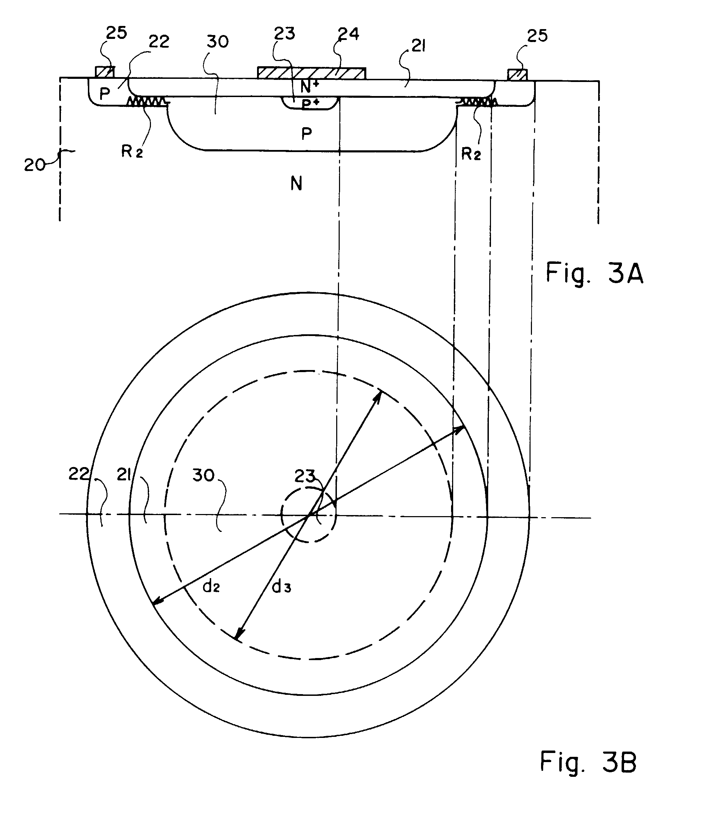

On retrouve en figures 3A et 3B des régions et zones analogues à celles illustrées en figures 2A et 2B et désignées par les mêmes références. Ainsi, on retrouve la couche P de base 22, la région 23 de type $P^+$ formant une jonction d'avalanche avec la région N$^+$ 21 et les métallisations 24 et 25 respectivement solidaires de la région N$^+$ 21 et de la région P 22. En outre, il est prévu une région P 30 apparaissant sous la région N$^+$ 21 sans déborder de celle-ci et entourant la région P$^+$ 23. Cette région P 30 résulte d'une diffusion telle que son niveau de dopage au voisinage de son interface avec la région 21 est plus faible que le niveau de dopage de la région 23 au voisinage de son interface avec la région 21, tout en étant plus élevé que celui de la région P 22.

Comme précédemment, la jonction susceptible de rentrer en avalanche est la jonction formée entre la région 23 et la région 21. Le trajet de courant entre la région 23 et la métallisation 25 passe d'abord par la région P 30 qui est une région relativement fortement dopée et épaisse et qui présente donc une résistance négligeable. Il existe toutefois encore une région pincée de la région P 22 entre la région N$^+$ 21 et le substrat 20 désignée par la résistance R$_2$. Ici, la résistance de la région pincée sera

$$R_2 = (r/2\pi) \, \text{Log}(d2/d3),$$

où

d2 désigne le diamètre de la région N 21 et
d3 le diamètre de la région P 30 au niveau de son interface avec la région N 21.

Avec cette structure, on peut garder une jonction de petite surface entre les régions 21 et 23 et rendre plus proche de 1 le rapport entre les valeurs d3/d2, pour réduire la résistance R$_2$, en augmentant la dimension de la région P 30 et donc corrélativement de la région N$^+$ 21.

On notera qu'il importe que la région N 21 déborde de la région P 30. Sinon, la jonction entre les régions 21 et 30 risquerait au niveau de la surface supérieure, de rentrer en avalanche avant la jonction entre les régions 21 et 23.

La structure décrite selon la présente invention est parfaitement compatible avec le procédé de fabrication d'un circuit intégré bipolaire tel qu'illustré en figure 1. En effet, la région P 30 pourra être une région correspondant à une diffusion P d'isolement (arrêtée éventuellement par une couche enterrée si l'isolement est entièrement effectué à partir de la surface), la région P$^+$ 23 une région correspondant aux diffusions d'émetteur de transistors PNP de puissance, et la région P 22 une région correspondant à la diffusion de base d'un transistor NPN. En pratique, ces régions successives seront fabriquées dans l'ordre ci-dessus énoncé, après quoi la région N$^+$ 21 de plus fort niveau de dopage que toutes les régions précédemment énumérées est formée.

Bien entendu, la présente invention est susceptible de diverses variantes qui apparaîtront à l'homme de l'art. Notamment, alors que l'on a représenté en vue de dessus une structure de forme circulaire avec une électrode de cathode centrale et une électrode d'anode annulaire, cette structure pourrait avoir toute autre forme souhaitée. Par exemple les diverses régions pourraient être des régions carrées emboîtées les unes dans les autres, des régions rectangulaires, des régions digitées etc., les paramètres guidant l'homme de l'art pour la fabrication d'une structure selon la présente invention étant le maintien d'une faible surface de jonction entre les régions 21 et 23 et une réduction de la différence d2-d3, qui est liée aux paramètres d'alignement de masques dans la technologie considérée.

A titre d'exemple de valeurs numériques, la profondeur d'une région N d'émetteur peut être de l'ordre de 3 μm ; la profondeur de diffusion d'une région P de base de l'ordre de 3,3 μm et sa résistance par carré de l'ordre de 120 ohms, ce qui conduit dans le cas d'une structure selon l'art antérieur à une résistance de base pincée de l'ordre de 4 kohms. Par contre, la résistance par carré d'une région P telle que la région P 30 de la figure 3A peut être de l'ordre de 40 ohms.

Dans un cas pratique on pourra choisir les valeurs numériques suivantes :

| | Concentration en surface ($cm^{-3}$) | Profondeur de jonction |
|---|---|---|
| Région N+ 21 | $2.10^{20}$ | 2,5 $\mu$m |
| Région P+ 30 | $2,5.10^{19}$ | 15 $\mu$m |
| Région P+ 23 | $4.10^{19}$ | 7 $\mu$m |
| Région P 22 | $3.10^{18}$ | 2,8 $\mu$m |

| | Diamètre des motifs dans l'oxyde avant diffusion | Diamètre, compte tenu de la diffusion latérale |
|---|---|---|
| Région P+ 23 | 6 $\mu$m | 20 $\mu$m |
| Région P+ 30 | 30 $\mu$m | 60 $\mu$m |
| Région N+ 21 | 57 $\mu$m | 62 $\mu$m |

La diffusion P 22 sera suffisante pour contenir la région 21. Elle n'est pas nécessairement circulaire.

On notera que les concentrations en surface des régions P+ 23 et 30 ne sont pas très différentes ; mais, les profondeurs de diffusion étant très différentes, les concentrations à une profondeur de 2,5 $\mu$m, c'est-à-dire au niveau de l'interface avec la région N+ 21, sont elles aussi très différentes.

**Revendications**

1. Diode à avalanche formée dans un circuit intégré bipolaire comprenant, dans une couche d'un premier type de conductivité (20) ayant une première surface, une première région du deuxième type de conductivité (22) s'étendant à partir de la première surface, une région du premier type de conductivité (21) disposée à l'intérieur de la première région de sorte que la portion de la première région disposée sous la région du premier type de conductivité et au voisinage de l'interface avec celle-ci présente un premier niveau de dopage, une deuxième région du deuxième type de conductivité (23) s'étendant sous la région du premier type de conductivité avec un deuxième niveau de dopage supérieur au premier au voisinage de la jonction, caractérisée en ce qu'elle comprend une troisième région du deuxième type de conductivité (30) disposée sous la région du premier type de conductivité et débordant par rapport à la deuxième région du deuxième type de conductivité, tout en restant à l'intérieur du contour de la région (21) du premier type de conductivité, cette troisième région ayant au niveau de son interface avec la région du premier type de conductivité un niveau de dopage intermédiaire entre les premier et deuxième niveaux de dopage.

2. Diode à avalanche selon la revendication 1, caractérisée en ce que :

la couche du premier type de conductivité correspond à la couche épitaxiée de type N du circuit intégré bipolaire,

la première région correspond aux régions de base de type P de transistors NPN du circuit intégré bipolaire,

la deuxième région correspond aux régions d'émetteur de type P de transistors PNP du circuit intégré bipolaire,

la troisième région correspond aux diffusions d'isolement de type P du circuit intégré bipolaire, et

la région du premier type de conductivité correspond aux régions d'émetteur des transistors NPN du circuit intégré bipolaire.

3. Diode à avalanche selon la revendication 1, caractérisée en ce que les diverses régions énoncées ont des contours circulaires.

**Patentansprüche**

1. In einer bipolaren integrierten Schaltung ausgebildete Lawinen- bzw. Avalanche-Diode, welche in einer Schicht (20) eines ersten Leitfähigkeitstyps mit einer ersten Oberfläche umfaßt: einen ersten Bereich (22) des zweiten Leitfähigkeitstyps, der sich von der ersten Oberfläche aus erstreckt, einen Bereich (21) des ersten Leitfähigkeitstyps, der im Inneren des ersten Bereichs so angeordnet ist, daß der unter dem Bereich des ersten Leitfähigkeitstyps und benachbart der Grenzfläche mit diesem liegende Teil des ersten Bereichs ein erstes Dotierungsniveau aufweist, sowie einen zweiten Bereich (23), der sich unter dem Bereich des ersten Leitfähigkeitstyps erstreckt mit einem zweiten Dotierungsniveau bzw. -pegel, der größer als der erste benachbart dem PN-Übergang ist, **dadurch gekennzeichnet,** daß die Diode einen dritten Bereich (30) vom zweiten Leitfähigkeitstyp umfaßt, der unter dem Bereich des ersten Leitfähigkeitstyps angeordnet ist und relativ bezüglich dem zweiten Bereich des zweiten Leitfähigkeitstyps über diesen hinausragt, jedoch innerhalb des Umfangs des Bereichs (21) des ersten Leitfähigkeitstyps verbleibt, wobei dieser dritte Bereich auf dem Niveau seiner Grenzfläche mit dem Bereich des ersten Leitfähigkeitstyps einen Dotierungspegel zwischen dem ersten und dem zweiten Dotierungspegel besitzt.

2. Lawinen- bzw. Avalanche-Diode nach Anspruch 1, dadurch gekennzeichnet, daß

- die Schicht vom ersten Leitfähigkeitstyp einer Epitaxialschicht vom N-Typ der bipolaren integrierten Schaltung entspricht,

- der erste Bereich den Basisbereichen vom P-Typ von NPN-Transistoren der bipolaren integrierten Schaltung entspricht,

- der zweite Bereich den Emitterbereichen vom P-Typ von PNP-Transistoren der bipolaren integrierten Schaltung entspricht,

- der dritte Bereich den Isolierdiffusionen vom P-Typ der bipolaren integrierten Schaltung entspricht, und

- der Bereich des ersten Leitfähigkeitstyps den Emitterbereichen der NPN-Transistoren der bipolaren integrierten Schaltung entspricht.

3. Lawinen- bzw. Avalanche-Diode nach Anspruch 1, dadurch gekennzeichnet, daß die verschiedenen aufgeführten Bereiche kreisförmige Umfangskonturen besitzen.

**Claims**

1. An avalanche diode formed in a bipolar integrated circuit comprising,

- in a layer (20) of a first conductivity type having a first surface, a first region (22) of the second conductivity type extending from the first surface, a region (21) of the first conductivity type disposed inside said first region so that the portion of the first region disposed under the region of the first conductivity type and close to the interface with the latter has a first doping level, a second region (23) of the second conductivity type extending under the region of the first conductivity type with a second doping level higher than the first close to the junction, and characterized in that it comprises a third region (30) of the second conductivity type disposed under the region of the first conductivity type and overlapping with respect to said second region of the second conductivity type, while remaining inside the outline of the region of the first conductivity type said third region having, at its interface with the region of the first conductivity type, a doping level intermediate the first and second doping levels.

2. An avalanche diode according to claim 1, characterized in that:

said layer of the first conductivity type corresponds to an N-type epitaxial layer of the bipolar integrated circuit, said first region corresponds to P-type base regions of NPN transistors of the bipolar integrated circuit, said second region corresponds to P-type emitter regions of PNP transistors of the bipolar integrated circuit, said third region corresponds to P-type insulation diffusions of the bipolar integrated circuit, and said region of the first conductivity type corresponds to emitter regions of NPN transistors of the bipolar integrated circuit.

3. An avalanche diode according to claim 1, characterized in that said various regions have circular outlines.

Fig. 1

Fig. 2 A

Fig. 2 B

Fig. 3A

Fig. 3B